Europäisches Patentamt

European Patent Office

Office européen des brevets

(19)

(11) Publication number: **0 155 823**
**B1**

(12) # EUROPEAN PATENT SPECIFICATION

(45) Date of publication of patent specification: **26.07.89**

(51) Int. Cl.⁴: **B 05 D 1/00**, B 05 D 7/24

(21) Application number: **85301777.0**

(22) Date of filing: **14.03.85**

(54) **Improvements in or relating to the covering of substrates with synthetic resin films.**

(30) Priority: **21.03.84 JP 52344/84**
**30.08.84 JP 179293/84**
**25.09.84 JP 200257/84**

(43) Date of publication of application:
**25.09.85 Bulletin 85/39**

(45) Publication of the grant of the patent:
**26.07.89 Bulletin 89/30**

(84) Designated Contracting States:
**CH DE FR GB LI**

(56) References cited:
**US-A-3 607 365**
**US-A-3 713 874**
**US-A-4 180 614**

**IBM TECHNICAL DISCLOSURE BULLETIN, vol. 20, no. 4, September 1977, page 1552, New York, US; J. DURAN et al.: "Preparation of thin polymide films by vacuum deposition"**
**IDEM**

(73) Proprietor: **NIHON SHINKU GIJUTSU KABUSHIKI KAISHA**
**2500, Hagisono**
**Chigasaki-shi Kanagawa-ken (JP)**

(72) Inventor: **Iijima, Masayuki**
**4-13-31, Kasuga Yatabemachi**
**Tsukuba-gun Ibaraki-ken (JP)**
Inventor: **Takahashi, Yoshikazu**
**3-12-15, Hanabatake Ohhomachi**
**Tsukuba-gun Ibaraki-ken (JP)**

(74) Representative: **Overbury, Richard Douglas et al**
**HASELTINE LAKE & CO Hazlitt House 28 Southampton Buildings Chancery Lane London WC2A 1AT (GB)**

## Description

This invention relates to the covering of substrates with synthetic resin films.

It is known, see for example IBM Technical Disclosure Bulletin Vol. 20 No. 4, September 1977 and/or US—A—3713874, to coat substrates with films of synthetic resin for various purposes. For example semiconductive elements may be covered with an insulating film, a passivating film, or a soft error preventing film; or a liquid crystal display element may be covered with a liquid crystal orientation film. Other substrates may be coated with a separation film for liquid or gas or with a photo resist.

For forming synthetic resin covering films of the above types, there have hitherto been used a wet process where a precursor for the synthetic resin is dissolved in a solvent and polymerized on the substrate; a polymer vapor deposition process where the synthetic resin itself is vaporised and vapors are deposited on the substrate; and a plasma polymerization process where a precursor for the synthetic resin is brought into a plasma condition and is polymerized on a substrate placed in the plasma atmosphere.

The foregoing three conventional processes, however, are not entirely satisfactory. More particularly, the wet process is such that it is very difficult to obtain an extremely thin film, and the adhesion of the film to the substrate is not always sufficient. Further it often happens that impurities are liable to be included in the film because the process involves such steps as the addition of solvent, removal of the solvent, recovery of the solvent, etc. The polymer vapor deposition process is such that the degree of polymerization of the film is often insufficient because decomposition and depolymerization often occur. The plasma polymerization process is such that control of the molecular structure of the synthetic resin is difficult because decomposition of the precursor often takes place and, in addition, the resultant synthetic resin film is comparatively rigid because cross-linking tends to occur.

It is an object of the present invention to enable synthetic resin covering films to be produced without the foregoing inconveniences and this is achieved by evaporating the precursor under vacuum and polymerising it on the substrate.

IBM Technical Disclosure Bulletin Vol. 20 No. 4 September 1977 discloses the preparation of thin polyimide films by vacuum deposition. A mixture of precursors for the polyimide is placed in a vacuum vessel below a substrate on which the film is to be formed and the vessel is evacuated. The substrate and the mixture are heated to cause evaporation of the mixture of precursors which reacts to form the polyimide film on the substrate. There is no suggestion to evaporate the precursors separately.

US 3713874 discloses the production of films by ultraviolet photopolymerisation of a polycarboxylic acid anhydride or dianhydride in the gaseous phase. The solid anhydride or dianhydride is introduced into an enclosure which is then evacuated. The anhydride or dianhydride is evaporated and caused to polymerise on the surface of a substrate by means of ultraviolet radiation.

Accordingly, one aspect of the present invention provides a process for covering a substrate with a synthetic resin film formed by the reaction of at least two precursors which process comprises evaporating the precursors under vacuum to form vapors of the precursors, contacting the substrate with the vapors, and reacting the precursors in contact with the substrate characterised in that said vacuum is from $1 \times 10^{-2}$ to about $1 \times 10^{-6}$ Torr and in that the precursors are separately evaporated.

The reason why the evaporation of the precursor(s) is carried out under vacuum conditions is that this prevents, to a large extent, the evaporated precursor molecules from impinging on one another or on the walls of the vessel in which the process is carried out. Consequently the precursor vapors can be adhered directly to the substrate and then polymerized thereon.

Thus in accordance with the process of the present invention at least two kinds of precursor for a predetermined synthetic resin are evaporated under vacuum in order that vapors thereof may be polymerized on a substrate. In this way uniform precursor vapors which do not contain any impurities or decomposed precursor can be deposited on the substrate and be brought into contact with each other thereon. Thus a satisfactory polymerization reaction can be effected, and a synthetic resin film which is fine in structure, high in purity and uniform in thickness and which has good adhesion to the substrate can be formed. Also, any desired covering film thickness, including extremely thin films, can be obtained.

The precursors may be monomers or oligomers and the process is not limited in regard to the nature or number of the monomers or oligomers which may be used. It is possible to make a synthetic resin of desired molecular structure by properly selecting the nature and the number of the monomers or oligomers to be used and any of various polymerisation reactions such as addition polymerization and condensation polymerization can be employed as appropriate.

Thus, by means of the present invention it is possible to produce coatings formed of, for example, a polyimide (e.g. using pyromellitic acid anhydride and 4,4'-diaminodiphenyl ether as precursors), a polyamide (e.g. using terephthalic acid dichloride and 4,4'-diaminodiphenyl ether as precursors), a polyurea (e.g. using 4,4'-diphenyl methane diisocyanate and 4,4'-diamino diphenyl ether as precursors) or a polyurethane (e.g. using 4,4'-diphenyl methane diisocyanate and p-hydroquinone as precursors).

If it is necessary to heat the precursors in order to cause the polymerization thereof, the precursors can be deposited on to a substrate which has been previously heated to a predetermined temperature or the substrate can be heated after the deposition of the precursors thereon at room temperature.

An initiator or the like for the polymerization reaction can be evaporated simultaneously with the evaporation of the precursors if the occasion demands.

According to a second aspect of the present invention, there is provided an apparatus for covering a substrate with a synthetic resin film by the process as mentioned above, the apparatus comprising a treatment chamber connected to a vacuum supply, a means located within the chamber for containing the precursors and from which the precursors are evaporated, a holder for the substrate which holder is located within the chamber and is disposed so that the substrate can be contacted by precursor vapors from the means for containing the precursors, and a heater for heating the precursors in the means for containing the precursors characterised in that the means for containing the precursors comprise a separate evaporation container for each precursor and in that the apparatus includes a shutter capable of being interposed between the substrate holder and the evaporation containers.

The substrate holder and the evaporation containers are so disposed as to face one another and, in a particularly preferred embodiment, the apparatus is designed to effect the polymerisation of the precursors by a thermal reaction. In this case, a heater for the substrate is provided at that side of the holder which is remote from the evaporation container. By means of such an apparatus, the evaporation amount of the precursor(s) and the polymerisation temperature can be controlled accurately.

In a further embodiment of the apparatus, a part of at least one of the evaporation containers is extended to the exterior of the treatment chamber. Precursor is placed in this extended part and heated and evaporated therein. In this way the vapour pressure of the precursor can be more easily controlled.

For a better understanding of the invention and to show how the same may be carried into effect, reference will now be made by way of example, to the accompanying drawings, in which:—

Figure 1 is a sectional view through one embodiment of an apparatus of the present invention, and

Figure 2 is a sectional view through another embodiment of an apparatus of the present invention.

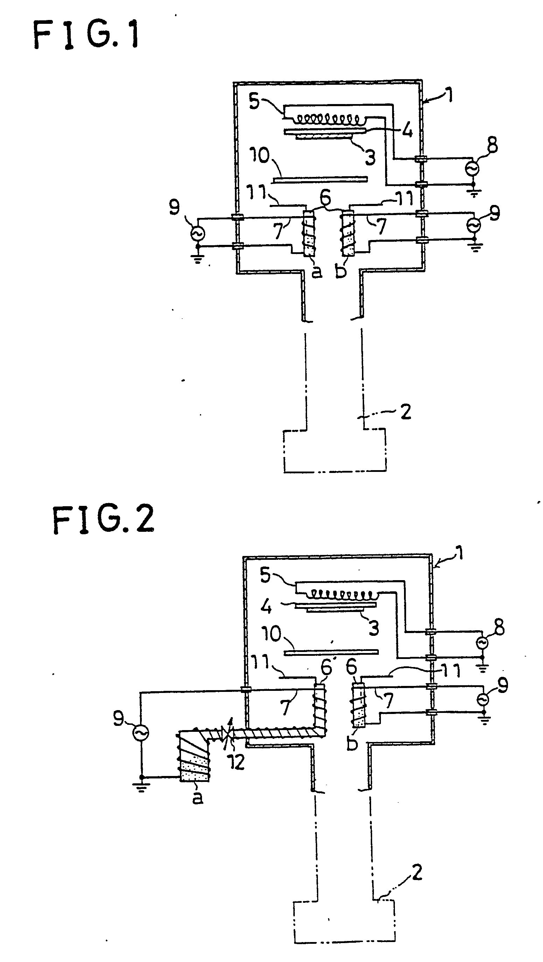

Referring now to Figure 1, there is shown an apparatus comprising a treatment chamber connected to a vacuum evacuation system 2 such as an exterior vacuum pump or the like. A substrate 3, on which a covering film of synthetic resin is to be formed, is so held by a substrate holder 4 in the treatment chamber 1 as to be directed downwards. The substrate 3 is arranged to be heated to a predetermined temperature by a heater 5 provided behind a back surface of the substrate holder 4. In addition, two glass tubular evaporation containers 6 for evaporating two different synthetic resin precursors a and b are so provided at a lower portion of the interior of the treatment chamber 1 as to be directed towards the substrate 3. Each of these evaporation containers 6 is arranged to be heated to a predetermined temperature by a heater 7 coiled around the same.

Referring to this Figure, numeral 8 denotes an electric power source for the heater 5, numeral 9 denotes an electric power source for the heater 7, and numeral 10 denotes a moveable shutter interposed between the substrate 3 and the evaporation containers 6. Numeral 11 denotes thermocouples inserted in each of the precursors a and b so that the temperatures thereof can be constantly measured and controlled by a suitable means (not shown) located externally of the treatment chamber.

The following Examples were carried out using an apparatus as shown in Fig. 1.

Example 1

In this Example a polyimide film was formed on a substrate from its precursors by a condensation polymerization reaction. Pyromellitic acid dianhydride (precursor a) was introduced into one of the evaporation containers 6 and 4,4'-diaminodiphenylether (precursor b) was charged into the other evaporation container. The total pressure of the atmosphere in the treatment chamber 1 was reduced to $1 \times 10^{-5}$ Torr by means of the vacuum evacuation system 2 with the shutter 10 closed i.e. in a position where it is interposed between the evaporation containers 6 and the substrate 3 in the holder 4.

Thereafter, while the temperatures of the respective precursors were being measured by the thermocouples 11 inserted in the respective evaporation containers 6, the pyromellitic acid dianhydride was heated to $175 \pm 2°C$, and the 4,4'-diaminodiphenylether was heated to $170 \pm 2°C$, by the respective heaters. After the precursors a and b had been brought to these predetermined temperatures (at which they begin to evaporate) the shutter 10 was opened so that it was no longer shielding the substrate 3 from the evaporation containers 6 whereby vapors of the precursors a and b were deposited on the substrate 3 to form a film of predetermined thickness at a deposition rate of 150 Å/min. Thereafter, the shutter 10 was closed again, and the substrate 3 was heated to 250°C by the heater 5. This temperature was kept for 40—60 minutes to bring about a polycondensation reaction of the precursors on the substrate 3 to form a polyimide covering film on the substrate 3.

The precursors a and b were caused to evaporate at a mol ratio of 1:1 in stoichiometric terms by adjusting the vapor pressures thereof so that the desired covering film was formed. The resultant polyimide covering film was fine in structure, high in purity, and had good adhesion to the substrate. In addition the film was by no means inferior to films formed by the conventional wet process in so far as various properties, such as electrical insulating property, chemical resistance, and heat resistance, were concerned.

Example 2

In this Example, a polyamide film was formed on a substrate, from its precursors by a condensation polymerisation reaction. Terephthalic acid dichloride (precursor *a*) and 4,4'-diaminodiphenylether (precursor *b*) were charged into their respective evaporation containers 6 and the total pressure of the atmosphere in the treatment chamber 1 was set at $1 \times 10^{-5}$ Torr by means of the vacuum evacuation system 2 with the shutter 10 closed. Thereafter, in almost the same manner as in Example 1, the terephthalic acid dichloride was heated to $64 \pm 2°C$ and the 4,4'-diaminodiphenylether was heated to $165 \pm 2°C$ by their respective heaters. In this case, the pressure in the treatment chamber 1 was set at $5 \times 10^{-3}$ Torr by the vapor pressure of the terephthalic acid dichloride in order that the respective precursors *a* and *b* may be evaporated in a mol ratio of 1:1.

Thereafter, the shutter 10 was opened, and vapors of the precursors *a* and *b* were deposited on the substrate 3 at a deposition rate of 60 Å/min., and polymerised together at room temperature. The shutter was closed when the resultant polymide film reached a predetermined thickness.

The polymerization reaction on the substrate 3 proceeded as follows. Firstly, vapors of the 4,4' diaminodiphenylether adhered to the substrate 3, and vapors of the simultaneously evaporated terephthalic acid dichloride were then brought into contact therewith so that the desired polymerization reaction took place on the substrate 3. Thereafter the two kinds of vapor were deposited thereon one after another and the polymerization reaction thus progressed.

The resultant polyamide covering film was fine in structure, high in purity, and had good adhesion to the substrate. In addition, it was by no means inferior to films formed by the conventional wet process in so far as various properties, such as electrical insulating property, chemical resistance, and heat resistance, were concerned.

Example 3

In this Example a polyurea covering film was formed on a substrate from its precursors by an additional polymerisation reaction.

4,4'-diaminodiphenylether diisocyanate (precursor *a*) and 4,4'-diaminodiphenylether (precursor *b*) were charged into their respective evaporation containers 6 and the whole pressure of the atmospheric gas in the treatment chamber 1 was set at $1 \times 10^{-5}$ Torr with the shutter 10 closed. Thereafter, the 4,4'-diphenylmethane diisocyanate and the 4,4'-diaminodiphenylether were heated, by the heaters 7 to $82 \pm 2°C$ and $140 \pm 2°C$, respectively. The shutter 10 was then opened and the precursors *a* and *b* were deposited on the substrate 3 at a deposition rate of 60 Å/min. The polymerization of the precursors on the substrate progressed at room temperature to form a polyurea covering film of a predetermined thickness. During this operation, the precursors *a* and *b* were evaporated in a mol ratio of 1:1 in stoichiometric terms by adjusting the vapor pressures thereof so that the desired covering film was formed.

The resultant polyurea covering film was fine in structure, high in purity and had good adhesion to the substrate. Further, it had better resistance than a comparable film formed in conventional manner.

Although, in Examples 2 and 3, the polymerization reaction was carried out at room temperature, the degree of polymerization of the resultant covering film could be adjusted by heating the substrate 3 to a predetermined temperature by means of the heater 5.

Example 4

In this Example, a polyurethane covering film was produced on the substrate from its precursors by an addition polymerisation reaction.

4,4'-diphenylmethane diisocyanate (precursor *a*) and p-hydroquinone (precursor *b*) were charged into their respective evaporation containers 6 and the whole pressure of the atmospheric gas in the treatment chamber 1 was set at $1 \times 10^{-5}$ Torr by means of the vacuum evacuation system 2.

Thereafter, with the shutter 10 closed, the 4,4'-diphenylmethane diisocyanate and the p-hydroquinone were heated by the heaters 7 to $82 \pm 2°C$ and $120 \pm 2°C$, respectively, in almost the same manner as in the foregoing example. The shutter 10 was then opened while the pressure was kept at $1 \times 10^{-5}$ Torr whereby the precursors *a* and *b* were deposited on the substrate 3 at a deposition rate of 600 Å/min., while the substrate 3 was being heated to 150°C. In this way, the precursors underwent a polymerization reaction on the substrate 3 to form a polyurethane covering film.

The polyurethane covering film thus produced in this example was also fine in structure, high in purity, and had good adhesion to the substrate. Its heat resistance was nearly equal to that of a comparable film formed in conventional manner.

Referring now to Figure 2, there is shown a modified apparatus adapted for the case where the precursor has a high vapor pressure for example as is the case when terephthalic acid dichloride is used. Parts corresponding to parts of Fig. 1 are denoted by like reference numerals. The evaporation container 6 for evaporating the precursor *a* includes a part which extends to the exterior of the treatment chamber 1 so that a precursor may be introduced, in the form of a vapor thereof, into the treatment chamber 1 after it has been charged and evaporated in the externally extended part. In this way, an adjustment of the gas pressure can be carried out easily. Numeral 12 denotes a valve for adjusting the amount of vapor introduced.

**Claims**

1. Process for covering a substrate with a synthetic resin film formed by the reaction of at least two precursors which process comprises evaporating the precursors under vacuum to form vapors of the precursors, contacting the substrate with the vapors, and reacting the precursors in contact with the substrate characterised in that said vacuum is from $1\times10^{-2}$ to $1\times10^{-6}$ Torr and in that the precursors are separately evaporated.

2. A process as claimed in claim 1, wherein the synthetic resin is formed from the precursors by a condensation polymerization reaction.

3. A process as claimed in claim 2, wherein the synthetic resin is a polyimide.

4. A process as claimed in claim 3, wherein the precursors comprise pyromellitic acid dianhydride and 4,4'-diaminodiphenylether.

5. A process as claimed in claim 2, wherein the synthetic resin is a polyamide.

6. A process as claimed in claim 5, wherein the precursors comprise terephthalic acid dichloride and 4,4'-diaminodiphenylether.

7. A process as claimed in claim 1, wherein the synthetic resin is formed by an addition polymerization reaction.

8. A process as claimed in claim 7, wherein the synthetic resin is a polyurea.

9. A process as claimed in claim 8, wherein the precursor comprise 4,4'-diphenylmethane diisocyanate and 4,4'-diaminodiphenylether.

10. A process as claimed in claim 7, wherein the synthetic resin is a polyurethane.

11. A process as claimed in claim 10, wherein the precursors comprise 4,4'-diphenylmethane diisocyanate and p-hydroquinone.

12. An apparatus for covering a substrate (3) with a synthetic resin film by the process claimed in claim 1 comprising a treatment chamber (1) connected to a vacuum supply (2), a means located within the chamber for containing the precursors and from which the precursors are evaporated, a holder (4) for the substrate (3) which holder (4) is located within the chamber (1) and is disposed so that the substrate (3) can be contacted by precursor vapors from the means for containing the precursors, and a heater (7) for heating the precursors in the means for containing the precursors characterised in that the means for containing the precursors comprises a separate evaporation container (6) for each precursor and in that the apparatus includes a shutter (10) capable of being interposed between the substrate holder (4) and the evaporation container (6).

13. An apparatus as claimed in claim 12 wherein a heater (5) is provided for heating the substrate (3) held by the substrate holder (4).

14. An apparatus as claimed in claim 12 or 13, wherein a part of at least one of the evaporation containers extends outside of the treatment chamber, said part being heatable and containing precursor.

**Patentansprüche**

1. Verfahren zur Beschichtung eines Substrates mit einem Kunststoffilm, der durch die Reaktion von wenigstens zwei Vorläufern gebildet wird, wobei das Verfahren enthält

— Verdampfen der Vorläufer unter Vakuum zur Bildung von Dämpfen der Vorläufer,

— in Kontakt bringen des Subtrats mit den Dämpfen, und Reaktion der Vorläufer mit dem in Kontakt gebrachten Substrat,

dadurch gekennzeichnet, daß das Vakuum von $1,33\times10^1$ bis $1,33\times10^{-3}$ Pa ($1\times10^{-2}$ bis $1\times10^{-6}$ Torr) ist und daß die Verläufer getrennt voneinander verdampft werden.

2. Verfahren gemäß Anspruch 1, beim dem der Kunststoff aus den Vorläufern durch eine Kondensations-Polymerisierungs-Reaktion gebildet wird.

3. Verfahren gemäß Anspruch 2, bei dem der Kunststoff ein Polyimid ist.

4. Verfahren gemäß Anspruch 3, bei dem die Vorläufer Pyromellitsäuredianhydrid und 4,4'-Diaminodiphenylether enthalten.

5. Verfahren gemäß Anspruch 2, bei dem der Kunststoff ein Polyamid ist.

6. Verfahren gemäß Anspruch 5, bei dem die Vorläufer Terephtalsäuredichlorid und 4,4'-Diaminodiphenylether enthalten.

7. Verfahren gemäß Anspruch 1, bei dem der Kunststoff durch eine Additions-Polymerisations-Reaktion gebildet wird.

8. Verfahren gemäß Anspruch 7, bei dem der Kunststoff ein Polyharnstoff ist.

9. Verfahren gemäß Anspruch 8, bei dem die Vorläufer 4,4'-Diphenylmethandiisocyanat und 4,4'-Diaminophenylether enthalten.

10. Verfahren gemäß Anspruch 7, bei dem der Kunststoff ein Polyurethan ist.

11. Verfahren gemäß Anspruch 10, bei dem die Vorläufer 4,4'-Diphenylmethandiisocyanat und p-Hydroquinon enthalten.

12. Vorrichtung zur Beschichtung eines Substrats (3) mit einem Kunststoffilm durch das Verfahren gemäß Anspruch 1 mit einer Behandlungskammer (1), die mit einem Vakuumanschluß (2) verbunden ist, einer Einrichtung innerhalb der Kammer zur Aufnahme der Vorläufer und von welcher die Vorläufer verdampft werden, einer Halterung (4) für das Substrat (3), wobei die Halterung (4) innerhalb der Kammer (1) gelegen und so angeordnet ist, daß das Substrat (3) mit Dämpfen der Vorläufer, die in dieser Einrichtung enthalten sind in Kontakt gebracht werden kann, und eine Heizeinrichtung (7) zur Erwärmung der Vorläufer in der Vorläuferaufnahme, dadurch gekennzeichnet, daß die Vorläuferaufnahme einen getrennten Verdampfungsbehälter (6) für jeden Vorläufer enthält und daß die Vorrichtung eine Verschlußeinrichtung (10) enthält, die dafür geeignet ist, zwischen der Substrathalterung (4) und dem Verdampfungsbehälter (6) angeordnet zu sein.

13. Vorrichtung gemäß Anspruch 12, bei der eine Heizeinrichtung (5) zur Erwärmung des durch die Substrathalterung (4) gehaltenen Substrats (3) vorgesehen ist.

14. Vorrichtung gemäß den Ansprüchen 12 oder 13, bei der ein Teil von wenigstens einem Verdampfungsbehälter sich außerhalb der Behandlungskammer erstreckt, wobei dieser Teil erwärmbar ist und Vorläufer enthält.

## Revendications

1. Procédé de revêtement d'un substrat d'un film de résine synthétique formé par la réaction d'au moins deux précurseurs, lequel procédé comprend l'évaporation des précurseurs sous vide pour former des vapeurs des précurseurs, la mise en contact du substrat avec les vapeurs et la réaction des précurseurs au contact du substrat, caractérisé en ce que ce vide est de $1 \times 10^{-2}$ à $1 \times 10^{-6}$ Torr et en ce que les précurseurs sont évaporés séparément.

2. Procédé suivant la revendication 1, dans lequel la résine synthétique est formée à partir des précurseurs par une réaction de polycondensation.

3. Procédé suivant la revendication 2, dans lequel la résine synthétique est un polyimide.

4. Procédé suivant la revendication 3, dans lequel les précurseurs comprennent du dianhydride de l'acide pyromellitique et de l'éther 4,4'-diaminodiphénylique.

5. Procédé suivant la revendication 2, dans lequel la résine synthétique est un polyamide.

6. Procédé suivant la revendication 5, dans lequel les précurseurs comprennent du dichlorure de l'acide téréphtalique et un éther 4,4'-diaminodiphénylique.

7. Procédé suivant la revendication 1, dans lequel la résine synthétique est formée par une réaction de polyaddition.

8. Procédé suivant la revendication 7, dans lequel la résine synthétique est une polyurée.

9. Procédé suivant la revendication 8, dans lequel le précurseur comprend du diisocyanate de 4,4'-diphénylméthane et de l'éther 4,4'-diaminodiphénylique.

10. Procédé suivant la revendication 7, dans lequel la résine synthétique est un polyuréthane.

11. Procédé suivant la revendication 10, dans lequel les précurseurs comprennent du diisocyanate de 4,4'-diphénylméthane et de la p-hydroquinone.

12. Appareil pour revêtir un substrat (3) d'un film de résine synthétique par le procédé revendiqué dans la revendication 1, comprenant une chambre de traitement (1) reliée à une source de vide (2), un moyen placé dans la chambre pour contenir les précurseurs et à partir duquel les précurseurs sont évaporés, un support (4) pour le substrat (3), lequel support (4) est placé dans la chambre (1) et est disposé de telle sorte que les vapeurs de précurseur provenant du moyen pour contenir les précurseurs viennent au contact du substrat (3) et un système de chauffage (7) pour chauffer les précurseurs dans le moyen pour contenir les précurseurs, caractérisé en ce que le moyen pour contenir les précurseurs comprend un récipient d'évaporation séparé (6) pour chaque précurseur et en ce que l'appareil comprend un volet d'obturation (10) pouvant être interposé entre le support du substrat (4) et le récipient d'évaporation (6).

13. Appareil suivant la revendication 2, dans lequel un système de chauffage (5) est prévu pour chauffer le substrat (3) maintenu par le support de substrat (4).

14. Appareil suivant les revendications 12 ou 13, dans lequel une partie d'au moins un des récipients d'évaporation s'étend à l'extérieur de la chambre de traitement, cette partie étant chauffable et contenant un précurseur.

# FIG.1

# FIG.2